(19) **Europäisches Patentamt**
**European Patent Office**
**Office européen des brevets**

(11) **EP 4 431 636 A1**

(12) **EUROPÄISCHE PATENTANMELDUNG**

(43) Veröffentlichungstag:
**18.09.2024   Patentblatt 2024/38**

(21) Anmeldenummer: **24161974.1**

(22) Anmeldetag: **07.03.2024**

(51) Internationale Patentklassifikation (IPC):
**C23C 30/00** (2006.01)    **C23C 2/00** (2006.01)
**C23C 2/06** (2006.01)    **C23C 2/40** (2006.01)
**C23C 14/16** (2006.01)    **C21D 8/02** (2006.01)

(52) Gemeinsame Patentklassifikation (CPC):
**C23C 2/06; C21D 8/0242; C21D 8/0278;**
**C23C 2/0038; C23C 2/006; C23C 2/40;**
**C23C 14/16; C23C 30/00**

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**GE KH MA MD TN**

(30) Priorität: **15.03.2023   DE 102023106421**

(71) Anmelder: **ThyssenKrupp Steel Europe AG**
**47166 Duisburg (DE)**

(72) Erfinder:
• **Schwerdt, Christian**
**47058 Duisburg (DE)**
• **Strack, Michael**
**45665 Recklinghausen (DE)**

(74) Vertreter: **ThyssenKrupp Steel Europe AG**
**Patente/Patent Department**
**Kaiser-Wilhelm-Straße 100**
**47166 Duisburg (DE)**

(54) **DRESSIERTES UND BESCHICHTETES STAHLBLECH**

(57)   Die Erfindung betrifft ein dressiertes und mit einem metallischen Überzug beschichtetes Stahlblech.

EP 4 431 636 A1

## Beschreibung

Die Erfindung betrifft ein dressiertes und mit einem metallischen Überzug beschichtetes Stahlblech.

Aus der WO 2016/042079 A1 ist ein Verfahren zum Beschichten von Substraten aus der Gasphase bekannt. Untersuchungen zu diesem beschriebenen Verfahren haben gezeigt, dass der aus der Gasphase applizierte Überzug der Oberflächenstruktur des Substrats folgt, jedoch sind die Beschichtungsraten sehr gering, da die einzelnen Atome überwiegend stoßfrei von der Verdampfungsquelle zum Substrat gelangen, um dort zu kondensieren (Molekularströmung).

Aus dem Stand der Technik ist ein Verfahren zum Beschichten aus der Gasphase bekannt, bei welchem ein mit einer deterministischen Oberflächenstruktur dressiertes Stahlblech eingesetzt wird, s. zum Beispiel Offenlegungsschrift DE 10 2020 207 561 A1.

Aus der DE 10 2018 220 678 A1 ist ferner eine optimierte Gasführung zum Beschichten aus der Gasphase bekannt.

Für die Beschichtung aus der Gasphase muss das in der Regel zu beschichtende Stahlband eine möglichst gute Planlage aufweisen. Ist dies nicht der Fall, kommt es zu einer ungleichmässigen Beschichtung und/oder zu einer Prozessstörung. Die eingesetzten Stahlbänder werden daher typischerweise vor der Beschichtung dressiert und/oder gerichtet. Neben der Aufgabe insbesondere beim Dressieren eine ausgeprägte Streckgrenze des Stahlbandes in den nachfolgenden Prozess-/Umformschritten zu verhindern, wird dabei die Planlage des Stahlbandes korrigiert, bei Bedarf zusätzlich durch Richten, und bei Bedarf eine vorteilhafte Oberflächenstruktur, welche die Umformeigenschaften begünstigen kann, über beispielsweise speziell texturierte Dressierwalzen eingestellt. Diese vorteilhafte Oberflächenstruktur kann nun durch die nachfolgende Beschichtung unvorteilhaft beeinflusst werden, so dass zur Einstellung einer der gewünschten Oberflächenstruktur ein weiterer Dressierstich notwendig wäre, da nach dem Beschichten die zuvor eingestellte Oberflächenstruktur nicht erhalten bleibt. Dies ist unwirtschaftlich und würde die Materialeigenschaften unvorteilhaft beeinflussen.

Die Aufgabe ist daher, ein Verfahren zum Beschichten eines unbeschichteten mit einer Oberflächenstruktur dressiertes Stahlband aus der Gasphase zur Verfügung zu stellen, welches ein optimales und im Wesentlichen homogenes Applizieren eines Überzugs ermöglicht.

Die Aufgabe wird in Bezug auf ein Stahlblech mit den Merkmalen des Patentanspruchs 1 und 2 gelöst.

Gemäß einer ersten Lehre sieht die Erfindung ein dressiertes und mit einem metallischen Überzug beschichtetes Stahlblech vor, wobei mindestens eine der Oberflächen des dressierten Stahlblechs angeordnete Einprägungen aufweist, wobei der Überzug durch eine Gasphasenabscheidung aufgebracht ist, wobei über eine Kreuzkorrelationsfunktion $r_{z,u}$ gemessene Höhenwerte $z_i$ am Stahlblech im beschichteten Zustand und gemessene Höhenwerten $u_i$ am Stahlblech im entschichteten Zustand im deckungsgleichen Bereich verglichen werden, wobei der sich aus der Kreuzkorrelationsfunktion $r_{z,u}$ ergebende Korrelationskoeffizient $r_1$ mindestens 0,50 beträgt.

Aus erfindungsgemäß dressierten und beschichteten Stahlblechen sind Proben erstellt worden, welche jeweils mit einer Oberfläche in beschichtetem sowie unbeschichtetem Zustand nach chemischem Entschichten im deckungsgleichen Bereich vermessen worden sind. Die Betrachtung des be- und entschichteten Bereichs ist somit deckungsgleich (gleiche Messflächen), soll heißen, dass eine untersuchte Probe in einer definierten Messfläche im beschichteten Zustand betrachtet wird und nach dem Entschichten in der gleichen/derselben definierten Messfläche wie vorher im beschichteten Zustand betrachtet wird. Insbesondere kann dadurch die Qualität der Applikation der Beschichtung auf dem Substrat erfasst werden. Ist der Korrelationskoeffizient hoch, mindestens 0,50, wird eine bessere und homogenere Applikation als im Stand der Technik geschlossen.

In Bezug auf die erste Lehre beträgt der Korrelationskoeffizient $r_1$ insbesondere mindestens 0,550, vorzugsweise mindestens 0,60, bevorzugt mindestens 0,650, besonders bevorzugt mindestens 0,70, weiter bevorzugt mindestens 0,750, 0,760, 0,770, 0,780, 0,790, 0,80, 0,810, 0,820, 0,830, 0,840, 0,850, 0,860, 0,870, 0,880, 0,890, 0,90, 0,910, 0,920, 0,930, 0,940. Ein Korrelationskoeffizient von 1 wäre theoretisch möglich, trifft aber mit hoher Wahrscheinlichkeit in der Praxis nie zu, so dass der Korrelationskoeffizient bis 1, insbesondere bis 0,990 betragen kann. Es wird angenommen, dass je höher der Korrelationskoeffizient, umso besser und homogener die Applikation des Überzugs abgeschieden aus der Gasphase auf dem Substrat.

Die Erfindung sieht gemäß einer zweiten Lehre ein dressiertes und mit einem metallischen Überzug beschichtetes Stahlblech vor, wobei mindestens eine der Oberflächen des dressierten Stahlblechs angeordnete Einprägungen aufweist, wobei der Überzug durch eine Gasphasenabscheidung aufgebracht ist, wobei über eine Kreuzkorrelationsfunktion $r_{z,u}$ gemessene Höhenwerte $z_i$ am Stahlblech von beschichteten Zustand und gemessene Höhenwerten $u_i$ am Stahlblech im entschichteten Zustand in unterschiedlichen Bereichen verglichen werden, wobei der sich aus der Kreuzkorrelationsfunktion $r_{z,u}$ ergebende Korrelationskoeffizient $r_2$ mindestens 0,40 beträgt.

Aus erfindungsgemäß dressierten beschichteten Stahlblechen sind Proben erstellt worden, welche jeweils mit einer Oberfläche in beschichtetem sowie unbeschichtetem Zustand nach chemischem Entschichten in unterschiedlichen Bereichen vermessen worden sind. Die Betrachtung des be- und entschichteten Bereichs überdecken sich somit nicht, soll heißen, dass eine untersuchte Probe in einer definierten Messfläche in einem ersten Bereich im beschichteten Zustand betrachtet wird und nach dem Entschichten in einer definierten Messfläche in einem zweiten Bereich, der nicht dem ersten Bereich entspricht, im beschichteten Zustand betrachtet wird. Die Größe der Messfläche ist bevorzugt identisch. Insbesondere kann dadurch die Qualität der Applikation der Beschichtung auf dem Substrat erfasst werden. Ist der Korrelationskoeffizient hoch, mindestens 0,30, wird eine bessere und homogenere Applikation als im Stand der Technik geschlossen.

In Bezug auf die zweite Lehre beträgt der Korrelationskoeffizient $r_2$ insbesondere mindestens 0,350, vorzugsweise mindestens 0,430, bevorzugt mindestens 0,50, besonders bevorzugt mindestens 0,520, weiter bevorzugt mindestens 0,550, 0,560, 0,570, 0,580, 0,590, 0,60, 0,610, 0,620, 0,630, 0,640, 0,650, 0,660, 0,670, 0,680, 0,690, 0,70, 0,710, 0,720, 0,750, 0,740. Ein Korrelationskoeffizient von 1 wäre theoretisch möglich, trifft aber mit hoher Wahrscheinlichkeit in der Praxis nie zu, so dass der Korrelationskoeffizient bis 1, insbesondere bis 0,90, vorzugsweise bis 0,850 betragen kann. Es wird angenommen, dass je höher der Korrelationskoeffizient, umso besser und homogener die Applikation des Überzugs abgeschieden aus der Gasphase auf dem Substrat.

Der Korrelationskoeffizienten $r_1$ und $r_2$ ergibt sich aus der Kreuzkorrelationsfunktion $r_{z,u}$ mit $r_{z,u} = \dfrac{s_{z,u}}{s_z * s_u}$ , wobei $s_{z,u}$ die Kovarianz ist und bestimmt wird durch $s_{z,u} = \dfrac{1}{n}\sum_{i=1}^{n}(z_i - \overline{z}) * (u_i - \overline{u})$ mit den Mittelwerten

$$\overline{z} = \frac{1}{n}\sum_{i=1}^{n} z_i \quad \text{und} \quad \overline{u} = \frac{1}{n}\sum_{i=1}^{n} u_i \quad \text{sowie den Standardabweichungen}$$

$$s_z = \sqrt{\frac{1}{n}\sum_{i=1}^{n}(z_i - \overline{z})^2} \quad \text{und } s_u = \sqrt{\frac{1}{n}\sum_{i=1}^{n}(u_i - \overline{u})^2} .$$

Die Mess- bzw. Auswertefläche sollte mindestens $0,5 \times 0,5$ mm$^2$ betragen. Ab $1,5 \times 1,5$ mm$^2$ können Form und Welligkeiten durch Filtermaßnahmen beseitigt werden. Die Ermittlung des Korrelationskoeffizienten sowie die dahinterliegenden Formeln sind Stand der Technik.

Unter Stahlblech ist allgemein ein Stahlflachprodukt zu verstehen, welches in Blechform (Blech) bzw. in Platinenform (Platine) oder in Bandform (Stahlband) bereitgestellt werden kann.

Das Beschichten durch Gasphasenabscheidung erfolgt in konventioneller Art und Weise und ist für den Fachmann geläufig.

Das Stahlblech ist mit einem beschichteten Überzug aus der Gasphase beschichtet. Das Dressieren erfolgt im unbeschichteten Zustand, somit vor dem Beschichten mittels Dressierwalzen. Die auf einer Dressierwalze erzeugten Erhöhungen bilden eine "positive" Form, welche beim Dressieren auf die Oberfläche eines (unbeschichteten) Stahlblechs einwirken und eine Oberflächenstruktur mit Einprägungen als "negative" Form einprägen. Ein vollständiges Einprägen/tauchen der Erhöhungen ist praktisch nicht möglich, so dass eine Übertragung der Form der Erhöhungen in bzw. auf die Oberfläche des unbeschichteten Stahlblechs größer 0 %, insbesondere größer 10 %, vorzugsweise größer 20 % und kleiner 100 %, insbesondere kleiner 90 %, vorzugsweise kleiner 85% ist.

Weitere vorteilhafte Ausgestaltungen und Weiterbildungen gehen aus der nachfolgenden Beschreibung hervor. Ein oder mehrere Merkmale aus den Ansprüchen, der Beschreibung wie auch der Zeichnung können mit einem oder mehreren anderen Merkmalen daraus zu weiteren Ausgestaltungen der Erfindung verknüpft werden. Es können auch ein oder mehrere Merkmale aus den unabhängigen Ansprüchen durch ein oder mehrere andere Merkmale verknüpft werden.

Gemäß einer Ausgestaltung ist das Stahlblech mit einer deterministischen Oberflächenstruktur dressiert worden ist. Unter deterministischer Oberflächenstruktur sind wiederkehrende Oberflächenstrukturen respektive Muster zu verstehen, welche eine definierte Form und/oder Ausgestaltung aufweisen, vgl. EP 2 892 663 B1. Insbesondere gehören hierzu zudem Oberflächen mit einer (quasi-)stochastischen Anmutung, die jedoch mittels eines deterministischen Texturierungsverfahrens aufgebracht werden und sich somit aus deterministischen Formelementen zusammensetzen.

Die geometrische Ausgestaltung (Größe und Tiefe) einer deterministischen Oberflächenstruktur (negative Form) auf einem dressierten Stahlblech hängt insbesondere davon ab, wie die entsprechende geometrische Struktur (positive Form) auf einer Dressierwalze gestaltet ist/wird. Vorzugsweise kommen Laser-Texturierverfahren zur Anwendung, um gezielte Strukturen (positive Form) auf der Oberfläche einer Dressierwalze durch Materialabtrag einstellen zu können. Insbesondere kann durch gezielte Ansteuerung der Energie, der Pulsdauer und Wahl einer geeigneten Wellenlänge eines auf die Oberfläche der Dressierwalze einwirkenden Laserstrahls positiv Einfluss auf die Gestaltung der Struktur(en) genommen werden. Mit hoher bzw. höherer Pulsdauer steigt die Wechselwirkungszeit von Laserstrahl und Dressierwalzenoberfläche und es kann mehr Material auf der Oberfläche der Dressierwalze abgetragen werden. Ein Puls hinterlässt auf der Dressierwalzenoberfläche einen im Wesentlichen kreisrunden Krater, der bzw. die, bei mehreren Kratern, nach dem Dressiervorgang die Oberfläche respektive die Fläche der Erhebungen auf dem Stahlblech und somit die Kontaktfläche zwischen Stahlblech und formgebender Dressierwalze abbildet. Eine Reduktion der Pulsdauer hat Einfluss auf die Ausbildung eines Kraters, insbesondere kann der Durchmesser des Kraters verringert werden.

Die Dressierwalze zur Ausbildung einer deterministischen Oberflächenstruktur kann mit geeigneten Mitteln bearbeitet werden, beispielsweise mittels Laser, vgl. auch EP 2 892 663 B1. Des Weiteren können auch andere Abtragverfahren zur Einstellung einer Oberfläche an einer Dressierwalze eingesetzt werden, beispielsweise spanende Fertigungsverfahren mit geometrisch bestimmter oder unbestimmter Schneide, chemische bzw. elektrochemische, optische oder plasmainduzierte Verfahren.

Gemäß einer alternativen Ausgestaltung ist das Stahlblech mit einer stochastischen Oberflächenstruktur dressiert worden ist. Stochastische Oberflächenstrukturen sind beispielhaft in der EP 2 006 037 B1 beschrieben. Verfahren und Mittel zur Einstellung von stochastischen Oberflächentexturen auf der Oberfläche von Dressierwalzen sind Stand der Technik.

Gemäß einer Ausgestaltung ist das Stahlblech mit einem Zinküberzug beschichtet. Das Abscheiden von (reinem) Zink auf der Oberfläche eines Stahlblechs ist beispielhaft aus der DE 100 39 375 A1 bekannt.

Gemäß einer alternativen Ausgestaltung ist Stahlblech mit einem zinkbasierten Überzug beschichtet, welcher neben Zink mindestens eines oder mehrere der Elemente aus Mangan, Magnesium, Aluminium umfasst, vgl. auch DE 100 39 375 A1.

Gemäß einer Ausgestaltung ist das Stahlblech mit einem ersten metallischen Überzug und auf dem ersten mit einem zweiten metallischen Überzug, wobei der zweite metallische Überzug aus der Gasphase abgeschieden worden ist, beschichtet. Der erste metallische Überzug, welcher unterhalb dem durch Gasphasenabscheidung applizierten metallischen Überzug angeordnet ist, somit direkt auf dem Stahlblech aufgebracht, kann mittels elektrolytischer Beschichtung oder aber mittels Schmelztauchbeschichtung aufgebracht sein.

Der aus der Gasphase abgeschiedene (zweite) metallische Überzug kann eine Dicke zwischen 1 und 25 $\mu$m aufweisen. Dabei kann eine Dicke des ersten metallischen Überzugs zwischen 1 und 30 $\mu$m betragen.

Ist eine elektrolytische Beschichtung als erster metallischer Überzug vorgesehen, so kann das Dressieren vor dem elektrolytischen Beschichten oder alternativ ein elektrolytisches Beschichten mit anschließendem Dressieren erfolgen. Ist alternativ eine Schmelztauchbeschichtung als erster metallischer Überzug vorgesehen, erfolgt vorzugsweise das Dressieren nach dem Beschichten des ersten metallischen Überzugs.

Stahlbleche wurden unterschiedlich mit einer deterministischen und einer stochastischen Oberflächentextur dressiert und anschließend wurden die unterschiedlich dressierten Stahlbleche mit einem zinkbasierten metallischen Überzug aus der Gasphase auf der dressierten Oberfläche der Stahlbleche abgeschieden. Die Dicke des Überzugs betrug 3,4 $\mu$m. Die Anlage zur Durchführung der Gasphasenabscheidung ist in der WO 2016/042079 A1 beschrieben. Die Parameter zur Durchführung sind in der folgenden Tabelle 1 aufgeführt.

Tabelle 1

| Blech | v | $P_S$ | $P_1$ | $t_{ein}$ | $t_{aus}$ | $t_T$ | $t_D$ | $t_K$ |
|---|---|---|---|---|---|---|---|---|
| 1 | 10 | 4 | 32 | 243 | 284 | 1000 | 1200 | 800 |
| 2* | 20 | 4 | 62 | 253 | 273 | 1000 | 1200 | 800 |
| 3 | 40 | 4 | 100 | 216 | 223 | 1000 | 1200 | 800 |
| 4* | 20 | 4 | 57 | 262 | 263 | 1000 | 1200 | 1000 |
| 5 | 20 | 4 | 60 | 245 | 276 | 1000 | 1200 | 1200 |

Definition der Parameter:

v      Geschwindigkeit des Stahlblechs durch die Anlage in m/min;
$P_S$      Sputter-Ätzer Leistung in kW;
$P_1$      Leistung Banderwärmung in kW;
$t_{ein}$      Einlauftemperatur Stahlblech in °C;
$t_{aus}$      Auslauftemperatur Stahlblech in °C;
$t_T$      Temperatur Tiegel in °C;
$t_D$      Temperatur Düse in °C;
$t_K$      Temperatur Kanal in °C;

\*      deterministische Oberflächenstruktur.

Des Weiteren wurden Oberflächenkennwerte nach DIN ISO 4788 ermittelt, welche wie folgt in der DIN ISO 4787 definiert sind:

Ra      arithmetischer Mittelwert der Rauheit des Oberflächenprofils in $\mu$m;
Rz      maximale Höhe des Oberflächenprofils in $\mu$m;
Rsk     Schiefe des Oberflächenprofils (dimensionslos);
RPc     Spitzenzahl des Oberflächenprofils in 1/cm;

sowie der Welligkeitswert Wsa und $Wa_{0.8}$ in $\mu$m nach der bzw. in Anlehnung der SEP 1941.

In der Tabelle 2 sind Oberflächenparameter aufgeführt, welche für die Oberseite der Stahlbleche im beschichteten sowie entschichteten Zustand ermittelt worden sind, wobei zum einen über eine Kreuzkorrelationsfunktion $r_{z,u}$ gemessene Höhenwerte $z_i$ am Stahlblech im beschichteten Zustand und gemessene Höhenwerten $u_i$ am Stahlblech im entschichteten Zustand im deckungsgleichen Bereich verglichen worden sind ---> $r_1$; und zum anderen über eine Kreuzkorrelationsfunktion $r_{z,u}$ gemessene Höhenwerte $z_i$ am Stahlblech im beschichteten Zustand und gemessene Höhenwerten $u_i$ am Stahlblech im entschichteten Zustand in unterschiedlichen Bereichen verglichen worden sind ---> $r_2$. Die erste Spalte in den jeweiligen Ausführungen bezieht sich auf den beschichteten Zustand und in der zweiten Spalte auf den entschichteten Zustand mit Ausnahme der Korrelationskoeffizienten.

Mittels konfokaler Auflichtmikroskopie und einer Messfläche mit $0{,}8 \times 0{,}8$ mm² wurden die Stahlbleche vermessen. Entschichtet wurde wie folgt: Abspülen der Proben mit Ethanol und Trocknen; Entzinken mit inhibierter Salzsäure (im Wesentlichen vollständiges Entfernen der Beschichtung); Abspülen mit Ethanol und Trocknen.

Die vermessenen Oberflächen der beschichteten und entschichteten Proben wurden einer mathematischen Korrelationsauswertung der Topographiedaten unterzogen ($\mu$soft analysis premium 6.2.6967) und die Korrelationskoeffizienten $r_1$ und $r_2$ ermittelt.

Tabelle 2

| Blech | Ra | Rz | Rsk | RPc | Wsa | $Wa_{0.8}$ | $r_1$ | $r_2$ |
|---|---|---|---|---|---|---|---|---|
| 1 | 1,23 | 6,94 | -0,40 | 53,1 | 0,38 | 0,51 | min. 0,55 | min. 0,55 |
|   | 1,08 | 6,23 | -0,29 | 44,4 | 0,34 | 0,47 | | |
| 2\* | 1,43 | 9,07 | -0,84 | 54,7 | 0,48 | 0,61 | min. 0,75 | min. 0,55 |
|   | 1,46 | 9,07 | -0,85 | 54,7 | 0,45 | 0,58 | | |
| 3 | 1,22 | 8,20 | -0,31 | 47,9 | 0,38 | 0,46 | min. 0,60 | min. 0,40 |
|   | 1,24 | 7,32 | -0,52 | 49,8 | 0,40 | 0,48 | | |
| 4\* | 1,19 | 7,18 | -0,26 | 47,6 | 0,39 | 0,51 | min. 0,70 | min. 0,50 |
|   | 1,23 | 6,98 | -0,25 | 51,7 | 0,43 | 0,55 | | |
| 5 | 1,14 | 6,80 | -0,43 | 48,2 | 0,38 | 0,48 | min. 0,65 | min. 0,45 |
|   | 1,20 | 7,12 | -0,41 | 51,7 | 0,38 | 0,51 | | |

Die Korrelationskoeffizienten $r_1$ und $r_2$ zu den Ausführungen 1 bis 5 liegen im Zielbereich, so dass von einer besseren und homogeneren Applikation des abgeschiedenen zinkbasierten Überzugs aus der Gasphase auf den dressierten Oberflächen der Stahlbleche ausgegangen werden kann.

**Patentansprüche**

**1.**   Dressiertes und mit einem metallischen Überzug beschichtetes Stahlblech ist, wobei mindestens eine der Oberflächen des dressierten Stahlblechs Einprägungen aufweist, wobei der Überzug durch eine Gasphasenabscheidung aufgebracht ist, **dadurch gekennzeichnet, dass** über eine Kreuzkorrelationsfunktion $r_{z,u}$ gemessene Höhenwerte $z_i$ am Stahlblech im beschichteten Zustand und gemessene Höhenwerten $u_i$ am Stahlblech im entschichteten Zustand im deckungsgleichen Bereich verglichen werden, wobei der sich aus der Kreuzkorrelationsfunktion $r_{z,u}$ ergebende Korrelationskoeffizient $r_1$ mindestens 0,50 beträgt.

**2.**   Dressiertes und mit einem metallischen Überzug beschichtetes Stahlblech ist, wobei mindestens eine der Oberflächen des dressierten Stahlblechs Einprägungen aufweist, wobei der Überzug durch eine Gasphasenabscheidung aufgebracht ist, **dadurch gekennzeichnet, dass** über eine Kreuzkorrelationsfunktion $r_{z,u}$ gemessene Höhenwerte $z_i$ am Stahlblech von beschichteten Zustand und gemessene Höhenwerten $u_i$ am Stahlblech im entschichteten Zustand in unterschiedlichen Bereichen verglichen werden, wobei der sich aus der Kreuzkorrelationsfunktion $r_{z,u}$ ergebende Korrelationskoeffizient $r_2$ mindestens 0,30 beträgt.

3. Stahlblech nach Anspruch 1 oder 2, wobei das Stahlblech mit einer deterministischen Oberflächenstruktur dressiert worden ist.

4. Stahlblech nach Anspruch 1 oder 2, wobei das Stahlblech mit einer stochastischen Oberflächenstruktur dressiert worden ist.

5. Stahlblech nach einem der vorhergehenden Ansprüchen, wobei das Stahlblech mit einem Zinküberzug beschichtet ist.

6. Stahlblech nach einem der Ansprüche 1 bis 4, wobei das Stahlblech mit einem zinkbasierten Überzug beschichtet ist, welcher neben Zink mindestens eines oder mehrere der Elemente aus Mangan, Magnesium, Aluminium umfasst.

7. Stahlblech nach einem der vorhergehenden Ansprüchen, wobei das Stahlblech mit einem ersten metallischen Überzug und auf dem ersten mit einem zweiten metallischen Überzug, wobei der zweite metallische Überzug aus der Gasphase abgeschieden worden ist, beschichtet ist.

Europäisches
Patentamt

European
Patent Office

Office européen
des brevets

**EUROPÄISCHER RECHERCHENBERICHT**

Nummer der Anmeldung

EP 24 16 1974

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 925 713 A1 (THYSSENKRUPP STEEL EUROPE AG [DE]) 22. Dezember 2021 (2021-12-22) <br> * Absatz [0011] * <br> * Absatz [0018] * <br> * Absatz [0026] - Absatz [0028] * <br> * Abbildung 2 * <br> * Ansprüche 1-8 * | 1-7 | INV. <br> C23C30/00 <br> C23C2/00 <br> C23C2/06 <br> C23C2/40 <br> C23C14/16 <br> C21D8/02 |
| A | BELOV VALERY ET AL: "Correlation between 3D Texture of Steel Substrate and TiN-Coated Surface with Various Coating Masses", <br> KEY ENGINEERING MATERIALS, TRANS TECH PUBLICATIONS, <br> Bd. 769, 27. April 2018 (2018-04-27), <br> Seiten 120-127, XP093184057, <br> CH <br> ISSN: 1662-9795, DOI: <br> 10.4028/www.scientific.net/KEM.769.120 <br> * Zusammenfassung * <br> * Introduction * <br> * 3. "Comparison of Surface Texture between Electrolytic Tinplate and Steel Substrate after Coating Removal" * <br> * Tabelle 2 * <br> * Abbildungen 4-5 * | 1-7 | |
| A | WO 2016/042079 A1 (FRAUNHOFER GES FORSCHUNG [DE]) 24. März 2016 (2016-03-24) <br> * Ansprüche 1-16 * | 1-7 | **RECHERCHIERTE SACHGEBIETE (IPC)** <br> C23C <br> C21D |
| A | EP 2 892 663 B1 (DAETWYLER GRAPHICS AG [CH]; THYSSENKRUPP STEEL EUROPE AG [DE]) 9. November 2016 (2016-11-09) <br> * Ansprüche 1-17 * | 1-7 | |

Der vorliegende Recherchenbericht wurde für alle Patentansprüche erstellt

| Recherchenort | Abschlußdatum der Recherche | Prüfer |
|---|---|---|
| Den Haag | 9. Juli 2024 | Neibecker, Pascal |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
.........................................................
& : Mitglied der gleichen Patentfamilie, übereinstimmendes
  Dokument

EPO FORM 1503 03.82 (P04C03)

ANHANG ZUM EUROPÄISCHEN RECHERCHENBERICHT
ÜBER DIE EUROPÄISCHE PATENTANMELDUNG NR.

EP 4 431 636 A1

EP 24 16 1974

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-07-2024

| Im Recherchenbericht angeführtes Patentdokument | Datum der Veröffentlichung | Mitglied(er) der Patentfamilie | Datum der Veröffentlichung |
|---|---|---|---|
| EP 3925713 A1 | 22-12-2021 | DE 102020207561 A1 | 23-12-2021 |
| | | EP 3925713 A1 | 22-12-2021 |
| WO 2016042079 A1 | 24-03-2016 | CN 107109626 A | 29-08-2017 |
| | | EP 3194635 A1 | 26-07-2017 |
| | | ES 2767400 T3 | 17-06-2020 |
| | | JP 6650442 B2 | 19-02-2020 |
| | | JP 2017528602 A | 28-09-2017 |
| | | KR 20170072882 A | 27-06-2017 |
| | | RU 2017108163 A | 18-10-2018 |
| | | US 2017283937 A1 | 05-10-2017 |
| | | WO 2016042079 A1 | 24-03-2016 |
| EP 2892663 B1 | 09-11-2016 | CN 104884180 A | 02-09-2015 |
| | | DE 102012017703 A1 | 13-03-2014 |
| | | EP 2892663 A1 | 15-07-2015 |
| | | ES 2612358 T3 | 16-05-2017 |
| | | JP 6334536 B2 | 30-05-2018 |
| | | JP 2015527203 A | 17-09-2015 |
| | | KR 20150068375 A | 19-06-2015 |
| | | KR 20160082264 A | 08-07-2016 |
| | | RU 2015112608 A | 27-10-2016 |
| | | US 2015209848 A1 | 30-07-2015 |
| | | WO 2014037545 A1 | 13-03-2014 |

EPO FORM P0461

Für nähere Einzelheiten zu diesem Anhang : siehe Amtsblatt des Europäischen Patentamts, Nr.12/82

8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016042079 A1
- DE 102020207561 A1
- DE 102018220678 A1

- EP 2892663 B1
- EP 2006037 B1
- DE 10039375 A1